# EUROPEAN PATENT APPLICATION

(11) **EP 4 350 792 A1**
(43) Date of publication of application: **10.04.2024**
(21) Application number: 22810926.0
(22) Date of filing: 11.03.2022
(51) Int. Cl.: H01L 51/46, H01L 51/50, H05B 33/26

(54) **ELECTRONIC DEVICE**

(30) Priority: 24.05.2021 JP 2021087223
(71) Applicant: Panasonic Holdings Corporation, Osaka 571-8501 (JP)
(72) Inventor: HIGUCHI Hiroshi, Kadoma-shi Osaka 571-0057 (JP)
(74) Representative: Grünecker Patent- und Rechtsanwälte PartG mbB
(86) International application number: PCT/JP2022/010961
(87) International publication number: WO 2022/249647

(57) **Abstract**

An electronic device 100 of the present disclosure comprises a first electrode 2, a photoelectric conversion layer 4, a hole transport layer 5, and a second electrode 6, which are disposed in the order stated. In the electronic device 100 of the present disclosure, the second electrode 6 comprises a conductive material and a first p-type dopant. The electronic device 100 of the present disclosure may further comprise, for example, an electron transport layer 3. The electron transport layer 3 is disposed, for example, between the first electrode 2 and the photoelectric conversion layer 4.

## Description

### Technical Field

The present disclosure relates to an electronic device.

### Background Art

Many electronic devices have a structure for performing a function of light absorption, light emission, amplification, rectification, or the like. The structure includes a photoelectric conversion layer with which a hole transport layer or an electron transport layer is in contact. The structure allows holes alone or electrons alone to be extracted or supplied in one direction.

The hole transport layer is a layer that has a function of transferring and accepting holes to and from a valence band of the adjoining photoelectric conversion layer while blocking electrons from a conduction band of the photoelectric conversion layer. The electron transport layer is a layer that has a function of transferring and accepting electrons to and from the conduction band of the adjoining photoelectric conversion layer while blocking holes from the valence band of the photoelectric conversion layer.

There are various hole transport materials that can serve as a main material that forms the hole transport layer. However, there are few materials that have a hole concentration that enables the materials by themselves to sufficiently serve as hole transport layers for electronic devices. In many instances, a necessary hole concentration is achieved by adding an additive to the hole transport material. That is, the additive is a material that has a function of removing electrons from the valence band of the hole transport material.

Perovskite solar cells have a structure including, for example, a first electrode, a photoelectric conversion layer, a hole transport layer, and a second electrode that are formed in this order. In some instances, an electron transport layer is additionally disposed between the first electrode and the photoelectric conversion layer. In perovskite solar cells, the photoelectric conversion layer is a layer that absorbs light to generate electrons and holes. The hole transport layer is a layer that conducts only the holes generated in the photoelectric conversion layer to the second electrode while blocking the electrons. The electron transport layer is a layer that conducts only the electrons generated in the photoelectric conversion layer to the first electrode while blocking the holes (Non Patent Literature 1).

Organic thin film solar cells have a structure including, for example, a first electrode, a photoelectric conversion layer, a hole transport layer, and a second electrode that are formed in this order. Organic thin film solar cells differ from perovskite solar cells in some respects regarding details of the operating principle, but organic thin film solar cells are similar to perovskite solar cells in that the hole transport layer is a layer that conducts only holes without conducting electrons, to transmit the holes to the second electrode (Patent Literature 1).

Organic electroluminescent devices, which include an organic compound that serves as a light emitting layer, have a structure including, for example, a first electrode, the light emitting layer, a hole transport layer, and a second electrode that are formed in this order. The hole transport layer of organic electroluminescent devices is a functional layer that conducts only holes without conducting electrons to the light emitting layer and, therefore, operates differently than that of perovskite solar cells or organic thin film solar cells, described above. However, the hole transport layer of organic electroluminescent devices is similar to that of perovskite solar cells or organic thin film solar cells in that the hole transport layer is a layer that has the function of conducting only holes without conducting electrons (Patent Literature 2).

Thus, the hole transport layer is a component that plays a central role in the operation of electronic devices. Unfortunately, there is a tendency for electronic devices to have degraded performance in instances in which the electrode on the hole transport layer is produced by the application of ink (Non Patent Literature 2).

Patent Literature 3 discloses an electrode containing a dopant with respect to an electron transport layer.

### Citation List

### Non Patent Literature

NPL 1: Materials Chemistry and Physics 256, p.123594 (2020)
NPL 2: Journral of Materials chemistry A, 3, p.15996 (2015)

### Patent Literature

PTL 1: Japanese Unexamined Patent Application Publication No. 2012-216673
PTL 2: Japanese Unexamined Patent Application Publication No. 2019-77685
PTL 3: International Publication No. 2011/052546

### Summary of Invention

### Technical Problem

An object of the present disclosure is to provide an electronic device having improved device performance.

### Solution to Problem

An electronic device of the present disclosure comprises a first electrode, a photoelectric conversion layer, a hole transport layer, and a second electrode that are disposed in the order stated. The second electrode comprises a conductive material and a first p-type dopant.

### Advantageous Effects of Invention

The present disclosure provides an electronic device having improved device performance.

### Brief Description of Drawings

[Fig. 1] Fig. 1 illustrates, in a cross-sectional view, a schematic configuration of a solar cell 100 of a first embodiment.
[Fig. 2] Fig. 2 illustrates, in a cross-sectional view, a schematic configuration of a solar cell 200 of the first embodiment.
[Fig. 3] Fig. 3 illustrates, in a cross-sectional view, a schematic configuration of a solar cell 300 of a second embodiment.
[Fig. 4] Fig. 4 illustrates, in a cross-sectional view, a schematic configuration of a solar cell 400 of the second embodiment.

### Description of Embodiments

Embodiments of the present disclosure will be described below with reference to the drawings.

### (First Embodiment)

An electronic device of a first embodiment comprises a first electrode, a photoelectric conversion layer, a hole transport layer, and a second electrode that are disposed in the order stated. The second electrode comprises a conductive material and a first p-type dopant.

In this specification, the "p-type dopant" is a material that serves as an acceptor when the material is added to a hole transport material that forms the hole transport layer, that is, a material that has a function of withdrawing electrons from a valence band of the hole transport material.

With the configuration described above, a reduction in a concentration of holes in the hole transport layer can be inhibited. As a result, performance of the electronic device of the first embodiment is improved.

In this specification, the "hole transport material" is a material that allows injection and drainage of holes therethrough and prevents injection and drainage of electrons therethrough.

The conductive material that forms the electrode is a material that allows injection and drainage of holes and electrons therethrough.

The electronic device of the first embodiment may further include a substrate.

The electronic device of the first embodiment may further comprise an electron transport layer disposed between the first electrode and the photoelectric conversion layer.

The electronic device of the first embodiment may be any electronic device as long as the electronic device includes the first electrode, the photoelectric conversion layer, the hole transport layer, and the second electrode that are disposed in the order stated. The electronic device of the first embodiment is, for example, a solar cell, a light emitting device, or an optical sensor. The electronic device of the first embodiment may be a solar cell, for example.

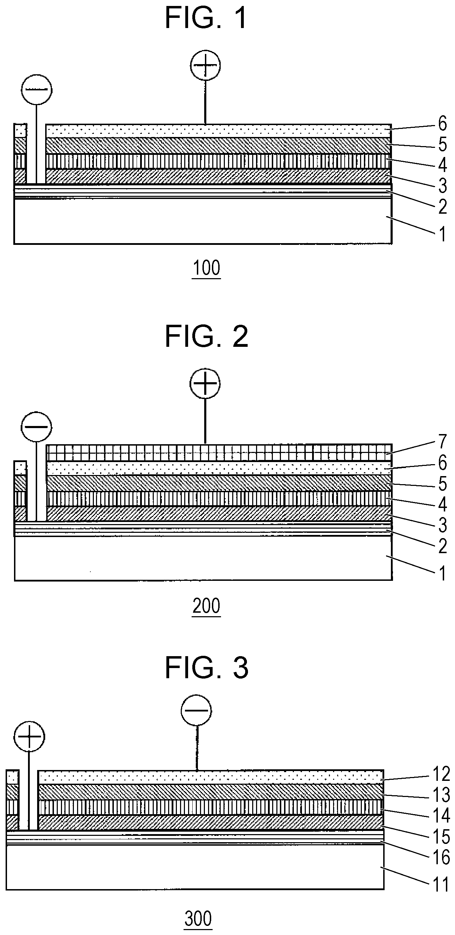

An example of a configuration of the electronic device of the first embodiment will be described with reference to Figs. 1 and 2. In the example, the electronic device is a solar cell.

Fig. 1 illustrates, in a cross-sectional view, a schematic configuration of a solar cell 100 of the first embodiment.

The solar cell 100 comprises a substrate 1, a first electrode 2, an electron transport layer 3, a photoelectric conversion layer 4, a hole transport layer 5, and a second electrode 6, which are disposed in the order stated.

The electronic device of the present disclosure may further comprise an auxiliary electrode electrically connected to the second electrode.

Fig. 2 illustrates, in a cross-sectional view, a schematic configuration of a solar cell 200 of the first embodiment.

The solar cell 200 has a configuration in which the solar cell 100 is provided with an auxiliary electrode 7. Specifically, the solar cell 200 comprises the substrate 1, the first electrode 2, the electron transport layer 3, the photoelectric conversion layer 4, the hole transport layer 5, the second electrode 6, and the auxiliary electrode 7, which are disposed in the order stated.

### (Substrate 1)

The substrate 1 serves to hold the layers of the solar cell. The substrate 1 is formed of a stable material that does not corrode or disappear during the steps of forming the first electrode 2, the photoelectric conversion layer 4, the hole transport layer 5, and the second electrode 6, on the substrate 1.

In instances where the solar cell is one that generates electricity from light coming from a substrate side, the material that forms the substrate 1 is a light-transmissive material.

The substrate 1 may be a ceramic substrate made of glass or the like or may be a plastic substrate. The plastic substrate may be a plastic film.

When the first electrode 2 has sufficient strength, the first electrode 2 can hold the layers of the solar cell, and, therefore, the substrate 1 need not be provided.

### (First Electrode 2)

A function of the first electrode 2 is to accept electrons generated in the photoelectric conversion layer 4 and allow the electrons to be extracted to an outside. The first electrode 2 is conductive. It is desirable that the first electrode 2 have low electrical resistance.

Examples of the material that forms the first electrode 2 include metals, conductive compounds that are electron conductive, and conductive carbons.

The metals are not limited, and substantially any metal may be used.

In instances where the first electrode 2 needs to be light-transmissive, it is desirable that the material be a light-transmissive conductive compound. Examples of the conductive compound include oxides of indium, zinc, or tin; oxides and nitrides of titanium; and organic conductive materials. Fluorine-doped tin oxide (SnO₂:F), indium tin oxide (ITO), Al-doped zinc oxide (ZnO:Al), Ga-doped zinc oxide (ZnO:Ga), Nb-doped titanium oxide (TiO₂:Nb), and barium tin oxide (BTO) have a low volume resistivity value. Accordingly, these can be used in solar cells for outdoor use, through which a large current is to be passed. SnO₂:F, ITO, ZnO:Al, ZnO:Ga, TiO₂:Nb, and BTO are also light-transmissive and, therefore, particularly useful for solar cells.

Examples of the conductive carbons include carbon blacks, carbon nanotubes (CNT), graphene, and graphite. Ketjen black and acetylene black are materials that are classified as carbon blacks.

Examples of methods for producing the first electrode 2 include vacuum deposition methods, such as sputtering, vapor deposition, and ion plating, screen printing, spray methods, and chemical vapor deposition (CVD) methods. The CVD method is a method that forms a film on a surface of the substrate 1 by injecting fine droplets or gas of a special material liquid onto the substrate 1 that has been heated. For example, the first electrode 2 may be produced by sputtering ITO onto the substrate 1 such that a sheet resistance of approximately greater than or equal to 10 Ω/□ and less than or equal to 40 Ω/□ is achieved.

### (Electron Transport Layer 3)

A function of the electron transport layer 3 is to accept electrons from the conduction band of the photoelectric conversion layer 4 and conduct the electrons to the first electrode 2, while blocking holes from the valence band of the photoelectric conversion layer 4.

Examples of the material that forms the electron transport layer 3 include titanium oxide and tin oxide.

Examples of methods for producing the electron transport layer 3 include a method in which a dispersion of TiO₂ nanoparticles in alcohol (concentration: 1 mass%) is applied by spinning or spraying, and thereafter, the alcohol is removed by applying heat at greater than or equal to 100°C. For example, the electron transport layer 3 may be produced by sputtering TiO₂ onto the first electrode 2 to a thickness of greater than or equal to 10 nm and less than or equal to 100 nm. In addition, an assembly of TiO₂ nanoparticles may be formed with a thickness of approximately greater than or equal to 100 nm and less than or equal to 500 nm, to provide the electron transport layer 3.

### (Photoelectric Conversion Layer 4)

A function of the photoelectric conversion layer 4 is to receive light coming from the substrate side or a side opposite thereto to generate electrons and holes and diffuse the electrons and the holes without allowing the electrons and the holes to recombine.

The photoelectric conversion layer 4 may contain a perovskite compound. The "perovskite compound" is a compound having a perovskite-type crystal structure represented by the composition formula of ABX₃ or a structure similar thereto. In the formula, A is a monovalent cation. Examples of the cation A include monovalent cations such as alkali metal cations and organic cations. Examples of the alkali metal cations include sodium cations (Na⁺), potassium cations (K⁺), cesium cations (Cs⁺), and rubidium cations (Rb⁺). Examples of the organic cations include methyl ammonium cations (CH₃NH₃⁺) and formamidinium cations (NH₂CHNH₂⁺). B is a divalent metal cation. Examples of the cation B include Pb cations, Sn cations, and Ge cations. X is a monovalent anion. Examples of the anion X include halogen anions. Examples of the halogen anions include iodine anions and bromine anions. The sites of the cation A, the cation B, and the anion X may each be occupied by more than one type of ion.

Examples of methods for producing the photoelectric conversion layer 4 include a method in which a solution containing specified materials dissolved in an organic solvent is applied, thereafter, the organic solvent is removed from the applied film, and thereafter, the resultant is heat-treated. The removal of the organic solvent from the applied film can be accomplished, for example, in either of the following ways or the like. One possible way is to reduce pressure, thereby volatilizing and removing the organic solvent. Another possible way is to add another solvent that is a poor solvent with respect to the specified materials dissolved in the organic solvent and which is compatible with the organic solvent, thereby exclusively removing the organic solvent from the applied film. These methods are common. These methods are simple and can produce a photoelectric conversion layer 4 having high performance. The methods for producing the photoelectric conversion layer 4 may include vacuum vapor deposition.

### (Hole Transport Layer 5)

A function of the hole transport layer 5 is to accept only holes from the photoelectric conversion layer 4 while blocking electrons. The hole transport layer 5 contains a hole transport material. It is desirable that the hole transport material have a HOMO (Highest Occupied Molecular Orbital) level close to the HOMO level of the photoelectric conversion layer 4 and a LUMO (Lowest Unoccupied Molecular Orbital) level higher than the LUMO level of the photoelectric conversion layer 4.

For example, in the instance of perovskite solar cells, the LUMO level of the photoelectric conversion layer 4 is approximately -4 eV, and the HOMO level thereof is approximately -5 eV. Accordingly, examples of the hole transport material include poly(bis(4-phenyl)(2,4,6-trimethylphenyl))amine (PTAA), N²,N²,N^{2'},N^{2'},N⁷,N⁷,N^{7'},N^{7'}-octakis(4-methoxyphenyl)-9,9'-spirobi[9H-fluorene]-2,2',7,7'-tetraamine (Spiro-OMeTAD), dithiophene-benzene copolymers (DTB), poly(3-hexylthiophene) (P3HT), and poly(3-hexylthiophene)-polystyrene block polymers (P3HT-b-PSt).

The hole transport layer 5 may contain at least one selected from the group consisting of PTAA, spiro-OMeTAD, DTB, P3HT, and P3HT-b-PSt. Note that these materials may not be able to provide a sufficient hole density of the hole transport layer by themselves. Accordingly, the hole transport layer 5 may include not only the hole transport material but also an additive. The additive has a function of removing electrons from the valence band of the hole transport material. That is, the hole transport layer 5 may comprise a p-type dopant. The p-type dopant that is included in the hole transport layer 5 is referred to as a "second p-type dopant".

The second p-type dopant may be any of the materials mentioned below as examples of the material of the first p-type dopant that is included in the second electrode 6. The second p-type dopant that may be included in the hole transport layer 5 may be a material that is the same as or different from the material of the first p-type dopant that is included in the second electrode 6. When the materials of the p-type dopants to be included in the hole transport layer 5 and the second electrode 6 are the same, the electronic device can be produced by a simple process. When the materials of the p-type dopants to be included in the hole transport layer 5 and the second electrode 6 are different from each other, p-type dopants having different properties can be used in the electronic device, and, therefore, the properties of the p-type dopants can be complementary to each other. For example, in instances where the hole transport layer 5 and the second electrode 6 contain a p-type dopant that is resistant to light and a p-type dopant that is resistant to heat, the resistance of the electronic device to light and heat can be improved.

The hole transport layer 5 may be formed in the following manner: a hole transport material and a second p-type dopant are dissolved in an organic solvent, and the resulting liquid is applied onto a layer that serves as an underlayer (e.g., the photoelectric conversion layer 4) and dried. The organic solvent to be used is, for example, an organic solvent that does not dissolve the first electrode 2, the electron transport layer 3, and the photoelectric conversion layer 4. Examples of such organic solvents include benzene, chlorobenzene, toluene, xylene, anisole, and mesitylene.

### (Second Electrode 6)

A function of the second electrode 6 is to accept holes generated in the photoelectric conversion layer 4 and allow the holes to be extracted to an outside.

The second electrode 6 comprises a conductive material and a first p-type dopant.

The conductive material may be any of the materials mentioned above as examples of the material that forms the first electrode 2. That is, examples of the conductive material include metals, conductive compounds that are electron conductive, and conductive carbons. The conductive material may be a carbon black or an acetylene black.

The first p-type dopant may comprise at least one selected from the group consisting of metal salts comprising a bis(trifluoromethanesulfonyl)imide group; metal salts comprising a bis(fluorosulfonyl)imide group; metal salts comprising a bis(pentafluoroethylsulfonyl)imide group; metal salts comprising a 4,4,5,5-tetrafluoro-1,3,2-dithiazolidine-1,1,3,3-tetraoxide group; tris(pentafluorophenyl)borane (TPFPB); 2,3,5,6-tetrafluoro-7,7,8,8-tetracyanoquinodimethane (F4-TCNQ); SnCl₄; SbCLs; FeCl₃; and WO₃.

The first p-type dopant may be at least one selected from the group consisting of metal salts comprising a bis(trifluoromethanesulfonyl)imide group; metal salts comprising a bis(fluorosulfonyl)imide group; metal salts comprising a bis(pentafluoroethylsulfonyl)imide group; metal salts comprising a 4,4,5,5-tetrafluoro-1,3,2-dithiazolidine-1,1,3,3-tetraoxide group; TPFPB; F4-TCNQ; SnCl₄; SbCLs; FeCl₃; and WO₃.

The first p-type dopant may comprise at least one selected from the group consisting of lithium bis(trifluoromethanesulfonyl)imide (LiTFSI) and TPFPB. The first p-type dopant may be at least one selected from the group consisting of LiTFSI and TPFPB.

With any of the configurations described above, it is possible to inhibit a reduction in a dopant concentration of the hole transport layer 5 that may occur if the p-type dopant present in the hole transport layer 5 flows into the second electrode 6. Consequently, a reduction in a concentration of the holes in the hole transport layer 5 can be inhibited. As a result, the performance of the solar cell 100 or the solar cell 200 is improved.

The first p-type dopant that is included in the second electrode 6 may be a material that is the same as or different from the material of the second p-type dopant that is included in the hole transport layer 5.

The second electrode 6 may contain two or more first p-type dopants.

The second electrode 6 need not contain the first p-type dopant uniformly. The second electrode 6 may comprise a dopant layer and a conductive layer. The dopant layer comprises the first p-type dopant. The dopant layer may comprise a conductive material. The conductive layer comprises a conductive material and is substantially free of the first p-type dopant. The dopant layer may be disposed between the hole transport layer 5 and the conductive layer, or the positions of the dopant layer and the conductive layer may be reversed. That is, the conductive layer may be disposed between the hole transport layer 5 and the dopant layer. The concentration of the first dopant in the dopant layer need not be uniform throughout the layer.

"The conductive layer is substantially free of the first p-type dopant" means that the conductive layer may contain a portion of the first p-type dopant that is incidentally included as an impurity, while not containing the first p-type dopant that serves as a constituent component. The "portion of the first p-type dopant that is incidentally included as an impurity" is a portion of the first p-type dopant that has moved into the conductive layer from the hole transport layer 5, for example, during production or as a result of repeated use of the solar cell. Note that an amount of the first p-type dopant that is incidentally included as an impurity in the conductive layer is, for example, less than or equal to 0.1 mass%.

The second electrode 6 may be composed of the dopant layer and the conductive layer.

The dopant layer may be in contact with the hole transport layer 5. In this case, it is possible to inhibit, to a greater degree, a reduction in the dopant concentration of the hole transport layer 5 that may occur if the p-type dopant present in the hole transport layer 5 flows into the second electrode 6. As a result, a reduction in the concentration of the holes can be inhibited.

In the second electrode 6, the concentration of the first p-type dopant may be greater than or equal to 0.4 mass% and less than 100 mass%, greater than or equal to 0.4 mass% and less than or equal to 80 mass%, greater than or equal to 0.4 mass% and less than 78 mass%, or greater than or equal to 0.4 mass% and less than or equal to 77.7 mass%. With this configuration, a reduction in the dopant concentration of the hole transport layer 5 can be inhibited to a greater degree, and, therefore, a reduction in the hole concentration of the hole transport layer 15 can be inhibited to a greater degree. As a result, the performance of the electronic device can be improved.

In the second electrode 6, when the first p-type dopant is LiTFSI, the concentration of the dopant may be greater than or equal to 0.8 mass% and less than 100 mass%, greater than or equal to 0.8 mass% and less than 78%, greater than or equal to 1.7 mass% and less than 100 mass%, or greater than or equal to 1.7 mass% and less than 78%. With this configuration, a reduction in the dopant concentration of the hole transport layer 5 can be inhibited, and, therefore, a reduction in a hole concentration of the hole transport layer 15 can be inhibited. As a result, the performance of the electronic device can be improved.

In the second electrode 6, when the first p-type dopant is TPFPB, the concentration of the dopant may be greater than or equal to 0.4 mass% and less than 100 mass% or greater than or equal to 0.4 mass% and less than 78%. With this configuration, a reduction in the dopant concentration of the hole transport layer 5 can be inhibited, and, therefore, a reduction in the hole concentration of the hole transport layer 15 can be inhibited. As a result, the performance of the electronic device can be improved.

The second electrode 6 is substantially free of the hole transport material. "The second electrode 6 is substantially free of the hole transport material" means that the second electrode 6 may contain a portion of the hole transport material that is incidentally included as an impurity, while not containing the hole transport material that serves as a constituent component. The "portion of the hole transport material that is incidentally included as an impurity" is a portion of the hole transport material that has moved into the second electrode 6 from the hole transport layer 5, for example, during production or as a result of repeated use of the solar cell. Note that an amount of the hole transport material that is incidentally included as an impurity in the second electrode 6 is, for example, less than or equal to 0.1 mass%.

The second electrode 6 may comprise a binder. When the method for producing the second electrode 6 is the application of an ink-like material, the inclusion of a binder in the second electrode 6 contributes to reducing a resistance of the second electrode and increasing robustness thereof.

Examples of the binder include polyvinylidene fluoride, polytetrafluoroethylene, polyhexafluoropropylene, polyethylene, polypropylene, polymethylmethacrylate, polyvinyl chloride, polyvinyl acetate, polyacrylic acid, polyvinyl butyral, polyacrylamide, polyurethane, polydimethyl siloxane, epoxy resins, acrylic resins, polyester resins, melamine resins, phenolic resins, various rubbers, lignins, pectins, gelatins, xanthan gums, welan gum, succinoglycans, polyvinyl alcohols, polyvinyl acetals, cellulose-based resins, polyalkylene oxides, polyvinyl ethers, polyvinylpyrrolidones, chitins, chitosans, and starches.

When the method for producing the second electrode 6 is the application of an ink-like material, the solvent to be selected for the ink-like material is, for example, one that does not dissolve the material to which the ink-like material is applied. Specifically, the solvent to be selected is, for example, one that does not corrode the hole transport layer 5, the photoelectric conversion layer 4, the first electrode 2, and the substrate 1.

Examples of solvents that are effective for perovskite solar cells and organic thin film solar cells include 1-propanol, 2-propanol, 1-butanol, 2-butanol, 1-pentanol, 2-pentanol, 3-pentanol, hexanol, heptanol, octanol, nonanol, decanol, undecanol, dodecanol, 1,2-propanediol, 1,3-propanediol, 1,2-pentadiol, 1,3-pentadiol, hexane, heptane, octane, nonane, decane, undecane, dodecane, hexamethyldisiloxane, hexamethoxydisiloxane, 1,1,3,3-tetramethyldisiloxane, 1,1,3,3,5,5,7,7,9,9,11,11-dodecamethylhexasiloxane, 1,1,5,5-tetramethyl-3,3-diphenyltrisiloxane, 1,1,1,3,3-pentamethyldisiloxane, methyl acetate, ethyl acetate, propyl acetate, butyl acetate, methyl cellosolve, ethyl cellosolve, propyl cellosolve, butyl cellsolve, dimethyl cellosolve, phenyl cellosolve, diisopropyl ether, ethylene glycol monoethyl ether acetate, propylene glycol monomethyl ether acetate, diethylene glycol monobutyl ether acetate, diethylene glycol monoethyl ether acetate, diethylene glycol monomethyl ether, diethylene glycol monoethyl ether, diethylene glycol monobutyl ether, propylene glycol monomethyl ether, propylene glycol monomethyl ether propionate, ethylene glycol dimethyl ether, diethylene glycol dimethyl ether, ethylene glycol diethyl ether, diethylene glycol diethyl ether, triethylene glycol dimethyl ether, diethylene glycol dibutyl ether, tetraethylene glycol dimethyl ether, and dipropylene glycol dimethyl ether.

Regarding the second electrode 6, it is not necessary to simultaneously form the conductive material and the first p-type dopant. For example, the second electrode 6 may be formed by first forming the layer containing the conductive material and subsequently incorporating the first p-type dopant. In this instance, the layer containing the conductive material may have a porous structure. Such a structure is advantageous in that the dopant can be easily incorporated at a later stage. Specifically, the second electrode 6 may be formed by a method in which after the layer containing the conductive material is formed, the layer is immersed in a liquid containing the first p-type dopant dissolved therein and thereafter dried, or the dopant is vapor-deposited onto the layer.

In the solar cell 100, illustrated in Fig. 1, the first electrode 2 is a negative electrode and has an exposed portion. The exposed portion of the first electrode 2 is created, for example, as follows. Portions of the electron transport layer 3, the photoelectric conversion layer 4, the hole transport layer 5, and the second electrode 6 corresponding to the portion of the first electrode 2 that is to be exposed are removed by performing laser scribing with laser irradiation or by performing mechanical scribing with a metal knife. Accordingly, the solar cell that serves as a device is completed.

When the second electrode 6 has a high resistance, the second electrode 6 may be provided with an auxiliary electrode 7 formed thereon, as in the solar cell 200, illustrated in Fig. 2. A function of the auxiliary electrode 7 is to allow a current from the second electrode 6 to be extracted to an outside without incurring much loss. The auxiliary electrode 7 may be formed of a low-resistance material.

### (Second Embodiment)

An electronic device of a second embodiment will be described below. Some of the descriptions given in the first embodiment may not be repeated.

An electronic device of the second embodiment comprises a substrate, a second electrode, a hole transport layer, a photoelectric conversion layer, and a first electrode that are disposed in the order stated. The second electrode comprises a first p-type dopant.

With this configuration, a reduction in the concentration of the holes in the hole transport layer can be inhibited. As a result, the performance of the electronic device of the second embodiment is improved.

The electronic device of the second embodiment may be a solar cell, for example.

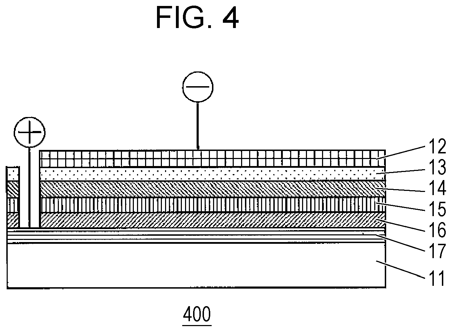

An example of a configuration of the electronic device of the second embodiment will be described with reference to Figs. 3 and 4. In the example, the electronic device is a solar cell.

Fig. 3 illustrates, in a cross-sectional view, a schematic configuration of a solar cell 300 of the second embodiment.

The solar cell 300 comprises a substrate 11, a second electrode 16, a hole transport layer 15, a photoelectric conversion layer 14, an electron transport layer 13, and a first electrode 12, which are disposed in the order stated.

Fig. 4 illustrates, in a cross-sectional view, a schematic configuration of a solar cell 400 of the second embodiment.

The solar cell 400 has a configuration in which the solar cell 300 is provided with an auxiliary electrode 17. Specifically, the solar cell 400 comprises the substrate 11, the auxiliary electrode 17, the second electrode 16, the hole transport layer 15, the photoelectric conversion layer 14, the electron transport layer 13, and the first electrode 12, which are disposed in the order stated.

Since the solar cell 400 comprises the auxiliary electrode 17, the solar cell 400 enables a current from the second electrode 16 to be extracted to an outside without incurring much loss.

The substrate 11 has the same configuration as the substrate 1, described in the first embodiment. The auxiliary electrode 17 has the same configuration as the auxiliary electrode 7, described in the first embodiment. The hole transport layer 15 has the same configuration as the hole transport layer 5, described in the first embodiment. The photoelectric conversion layer 14 has the same configuration as the photoelectric conversion layer 4, described in the first embodiment. The electron transport layer 13 has the same configuration as the electron transport layer 3, described in the first embodiment. The first electrode 12 has the same configuration as the first electrode 2, described in the first embodiment.

A function of the second electrode 16 is to accept holes from the hole transport layer 15 and allow the holes to be extracted to an outside. The second electrode 16 comprises a conductive material and a first p-type dopant. Conductive materials that can be used in the second electrode 16 are the same as the materials mentioned above, in the first embodiment, as examples of the material that forms the first electrode 2. That is, examples of the conductive material include metals, conductive compounds that are electron conductive, and conductive carbons. The conductive material may be a carbon black or an acetylene black.

With the configuration described above, a reduction in the concentration of the holes in the hole transport layer 15 can be inhibited. As a result, the performance of the solar cell 300 or the solar cell 400 is improved.

The first p-type dopant that is included in the second electrode 16 may be a material that is the same as or different from the material of the second p-type dopant, which may be included in the hole transport layer 15 formed on the second electrode 16.

The second electrode 16 may contain two or more first p-type dopants.

The second electrode 16 need not contain the first p-type dopant uniformly. The second electrode 16 may comprise a dopant layer and a conductive layer. The dopant layer comprises the first p-type dopant. The dopant layer may comprise a conductive material. The conductive layer comprises a conductive material and is substantially free of the first p-type dopant. The dopant layer may be disposed between the hole transport layer 15 and the conductive layer, or the positions of the dopant layer and the conductive layer may be reversed. That is, the conductive layer may be disposed between the hole transport layer 15 and the dopant layer. The concentration of the dopant in the dopant layer need not be uniform throughout the layer.

The second electrode 6 may be composed of the dopant layer and the conductive layer.

In the second electrode 16, the concentration of the first p-type dopant may be greater than or equal to 0.4 mass% and less than 100 mass%, greater than or equal to 0.4 mass% and less than or equal to 80 mass%, greater than or equal to 0.4 mass% and less than 78 mass%, or greater than or equal to 0.4 mass% and less than or equal to 77.7 mass%. With this configuration, a reduction in the second dopant concentration of the hole transport layer 15 can be inhibited to a greater degree, and, therefore, a reduction in the hole concentration of the hole transport layer 15 can be inhibited to a greater degree. As a result, the performance of the electronic device can be improved.

In the second electrode 16, the first p-type dopant may be LiTFSI, and the concentration of the dopant may be greater than or equal to 0.8 mass% and less than 100 mass%, greater than or equal to 0.8 mass% and less than 78%, greater than or equal to 1.7 mass% and less than 100 mass%, or greater than or equal to 1.7 mass% and less than 78 mass%. With this configuration, a reduction in the dopant concentration of the hole transport layer 15 can be inhibited, and, therefore, a reduction in the hole concentration of the hole transport layer 15 can be inhibited. As a result, the performance of the electronic device can be improved.

In the second electrode 16, the first p-type dopant may be TPFPB, and the concentration of the dopant may be greater than or equal to 0.4 mass% and less than 100 mass% or greater than or equal to 0.4 mass% and less than 78%. With this configuration, a reduction in the dopant concentration of the hole transport layer 15 can be inhibited, and, therefore, a reduction in the hole concentration of the hole transport layer 15 can be inhibited. As a result, the performance of the electronic device can be improved.

Similar to the second electrode 6, the second electrode 16 may comprise a binder. When the method for producing the second electrode 16 is the application of an ink-like material, the solvent to be selected for the ink-like material is, for example, one that does not corrode the substrate 11.

The method for producing the hole transport layer 15 is as described above in the first embodiment.

Examples of methods for producing the photoelectric conversion layer 14 include a method in which a solution containing specified materials dissolved in an organic solvent is applied, thereafter, pressure is reduced to vaporize and remove the organic solvent, and thereafter, the resultant is heat-treated.

Examples of methods for producing the electron transport layer 13 include a method in which TiO₂ or SnO₂ is sputtered. Alternatively, the electron transport layer 13 may be formed as follows: a dispersion of TiO₂ nanoparticles in alcohol (concentration: 1 mass%) is applied by spinning or spraying, thereafter, the alcohol is removed by applying heat at greater than or equal to 100°C, and subsequently, TiO₂ or SnO₂ is sputtered.

Examples of methods for producing the first electrode 12 include vacuum deposition, such as sputtering and vapor deposition, which may be performed with indium tin oxide (ITO), Al-doped zinc oxide (ZnO:Al), Ga-doped zinc oxide (ZnO:Ga), Nb-doped titanium oxide (TiO2:Nb), or barium tin oxide (BTO).

### EXAMPLES

The present disclosure will now be described in more detail with reference to examples. In the examples, perovskite solar cells were produced, and the device performance thereof was evaluated.

### (Examples 1 to 9)

The method used to produce the solar cells of Examples 1 to 9 will be described below.

A sheet of glass measuring 25 mm × 25 mm × 0.7 mm thick was prepared to be used as a substrate. Indium tin oxide (ITO) was sputtered onto one side of the glass such that a sheet resistance of 10 Ω/□ was achieved. In this manner, the first electrode was formed on the substrate.

Titanium oxide (TiO₂) was sputtered onto the first electrode to a thickness of 30 nm.

In addition, a nanoparticle assembly of TiO₂ was formed with a thickness of 250 nm. In this manner, the electron transport layer was formed on the first electrode.

Next, a raw material solution for the photoelectric conversion layer was prepared. The raw material solution was a liquid in which 2.91 g of formamidinium hydroiodide ((NH₂)₂CH₂I), 0.57 g of methyl ammonium hydroiodide (CH₃NH₃I), and 10 g of lead iodide (PbI₂) were dissolved in a solvent mixture of 23.3 mL of N,N-dimethylformamide (DMF) and 5.8 mL of dimethyl sulfoxide (DMSO). The raw material solution (80 µL) was added dropwise onto the electron transport layer, and then, the substrate including the electron transport layer was rotated in a spin coater at 4000 rpm for 70 seconds. After 30 to 60 seconds elapsed from the start of the rotation, 1 mL of toluene was pipetted onto the electron transport layer that was being rotated, which included the raw material solution added dropwise thereto. Subsequently, the resultant was heated on a hot plate at 115°C for 30 minutes. In this manner, the photoelectric conversion layer was formed on the electron transport layer.

Next, a hole transport material liquid was prepared. The hole transport material liquid was prepared by adding 4.8 µL of a solution, in which 500 mg of LiTFSI was dissolved in 1 mL of acetonitrile, to a solution prepared by adding 10 mg of PTAA and 6 µL of tert-butylpyridine to 1 mL of toluene. The hole transport layer was formed by a process in which 60 µL of the hole transport material liquid was added dropwise onto the photoelectric conversion layer, and then, rotation was applied at 4000 rpm for 30 seconds with a spin coater.

500 µL of carbon ink was added dropwise onto the hole transport layer, then, rotation was applied at 1000 rpm for 30 seconds with a spin coater, and subsequently, the resultant was heated on a hot plate at 100°C for 2 hours. The carbon ink was prepared as follows. 9 parts by mass of acetylene black and 1 part by mass of cellulose were added to a bead mill, thereafter, 2-propanol, in the amount shown in Table 1, was added thereto, and the contents were stirred. Subsequently, LiTFSI or TPFPB, which was used as the p-type dopant, was added in the amount shown in Table 1. In this manner, the second electrode was formed on the hole transport layer. Au was formed on the second electrode to a thickness of 200 nm by vapor deposition. In this manner, an auxiliary electrode was formed.

In the manner described above, the solar cells of Examples 1 to 9 were produced.

### (Comparative Example 1)

A solar cell of Comparative Example 1 was produced as in Examples 1 to 9, except that no p-type dopant was added to the carbon ink that was added dropwise onto the hole transport layer.

### (Measurement of Mass of Second Electrode)

The second electrode was stripped with a metal knife, and the mass of the second electrode was measured with an electronic balance.

### (Measurement of Mass of LiTFSI Present in Second Electrode)

The chips of the second electrode that were stripped were placed in a platinum crucible and heated at 800°C for 1 hour in an electric furnace for ashing. A small amount of nitric acid was added to the residue, which was dissolved by being heated. The resultant was diluted with purified water and subjected to inductively coupled plasma emission spectroscopy (ICP-AES) in an inductively coupled plasma emission spectrometer (iCAP 7400 Duo, manufactured by Thermo Fisher Scientific, Inc.). Accordingly, an amount of Li was determined, and an estimated mass of LiTFSI was calculated.

### (Measurement of Mass of TPFPB Present in Second Electrode)

An amount of B was determined by inductively coupled plasma emission spectroscopy (ICP-AES) in a manner similar to that described above, and an estimated mass of TPFPB was calculated.

The concentration of the p-type dopant in the second electrode of each of the solar cells was calculated from the measured masses. The "concentration of the p-type dopant in the second electrode" is a mass fraction of the first p-type dopant in the second electrode. Table 1 shows the concentration of the p-type dopant in the second electrode of the solar cells of Examples 1 to 9.

### (Evaluation 1)

A property of the produced solar cells of Examples 1 to 9 and Comparative Example 1 was evaluated under fluorescent light. The fluorescent light (illuminance: 200 lx) was projected onto the solar cells in a manner such that the light entered the solar cells from the glass surface side, the glass being the substrate. The glass surface had a light-blocking mask attached thereto, and the light-blocking mask had an opening area shape of 0.4 cm × 0.25 cm, so that a light-receiving area could be defined. A current value at an operating voltage of 0.6 V was measured with a source meter (6246, manufactured by ADC Corporation). Hereinafter, the operating voltage is also referred to as "Vop". Table 1 shows the current values at Vop=0.6 V at an illuminance of 200 lx of the solar cells of Examples 1 to 9 and Comparative Example 1.

### (Evaluation 2)

A property of the produced solar cells of Examples 1 to 9 and Comparative Example 1 was evaluated under simulated sunlight. The light, at 1 sun intensity, was projected onto the solar cells with a solar simulator in a manner such that the light entered the solar cells, via a light-blocking mask, from the glass surface side, the glass being the substrate. The light-blocking mask had an opening area shape of 0.4 cm × 0.25 cm. A voltage-current characteristic over a voltage range of -0.2 V to +1.2 V was measured with a source meter (6246, manufactured by ADC Corporation), and the power at a maximum power point was determined. Table 1 shows the maximum powers of the solar cells of Examples 1 to 9 and Comparative Example 1.

**[Table 1]**

| | Composition of ink for second electrode | | | | | P-type dopant concentration in second electrode (wt/wt) | 200-lx performance | 1-SUN performance |
|---|---|---|---|---|---|---|---|---|
| | Acetylene black (g) | Cellulose (g) | LiTFSI (g) | TPFPB (g) | 2-Propanol (g) | | Current at Vop=0.6 V (µA/cm²) | Maximum power (mW/cm²) |
| Comparative Example 1 | 9.0 | 1.0 | 0.00 | 0.00 | 30.7 | 0.000 | 9.4 | 2.23 |
| Example 1 | 9.0 | 1.0 | 0.04 | 0.00 | 30.8 | 0.004 | 13.9 | 11.33 |
| Example 2 | 9.0 | 1.0 | 0.17 | 0.00 | 31.0 | 0.017 | 24.6 | 13.44 |
| Example 3 | 9.0 | 1.0 | 1.62 | 0.00 | 33.2 | 0.139 | 16.5 | 14.63 |
| Example 4 | 9.0 | 1.0 | 4.85 | 0.00 | 38.1 | 0.326 | 16.9 | 12.36 |
| Example 5 | 9.0 | 1.0 | 9.69 | 0.00 | 45.5 | 0.492 | 26.3 | 17.37 |
| Example 6 | 9.0 | 1.0 | 17.4 | 0.00 | 30.7 | 0.635 | 24.3 | 13.32 |
| Example 7 | 9.0 | 1.0 | 34.8 | 0.00 | 30.7 | 0.777 | 22.2 | 10.85 |
| Example 8 | 9.0 | 1.0 | 0.00 | 1.62 | 33.2 | 0.139 | 23.4 | 12.57 |
| Example 9 | 9.0 | 1.0 | 0.00 | 4.85 | 38.1 | 0.326 | 23.6 | 11.98 |

### (Discussion 1)

As shown in Table 1, the current values regarding Evaluation 1 and the values of the maximum power regarding Evaluation 2 of Examples 1 to 7 are greater than those of Comparative Example 1. The inclusion of LiTFSI, which is a p-type dopant, in the second electrode improves the properties of the solar cells. Furthermore, the properties of the solar cells are improved when the concentration of LiTFSI in the second electrode is within a range of 0.4 mass% to 77.7 mass%.

The current values regarding Evaluation 1 and the values of the maximum power regarding Evaluation 2 of Examples 8 and 9 are greater than those of Comparative Example 1. This indicates that even when the p-type dopant included in the second electrode is TPFPB while the p-type dopant already included in the hole transport layer is LiTFSI, the properties of the solar cells are improved. That is, it was demonstrated that the p-type dopant included in the second electrode is not limited to the dopant present in the hole transport layer, that is, may be a different material.

### (Examples 10 to 18)

The method used to produce the solar cells of Examples 10 to 18 will be described below. The components other than the hole transport layer or the second electrode were produced as in Examples 1 to 9, and, therefore, descriptions thereof are not provided here.

The hole transport layer was formed by a process in which 60 µL of a hole transport material liquid was added dropwise onto the photoelectric conversion layer, and then, rotation was applied at 4000 rpm for 30 seconds with a spin coater. The hole transport material liquid was prepared by adding 0.1 g of PTAA to a glass container, then, adding 10 mL of a TPFPB solution thereto, and shaking the container for 2 hours. The TPFPB solution was prepared by dissolving 1 g of a TPFPB powder in 10 mL of toluene. That is, the hole transport layers of Examples 10 to 18 were different from those of Examples 1 to 9 in that the p-type dopant that was included was TPFPB.

500 µL of carbon ink was added dropwise onto the hole transport layer, then, rotation was applied at 1000 rpm for 30 seconds with a spin coater, and subsequently, the resultant was heated on a hot plate at 100°C for 2 hours. The carbon ink was prepared as follows. 9 parts by mass of acetylene black and 1 part by mass of cellulose were added to a bead mill, thereafter, 2-propanol, in the amount shown in Table 2, was added thereto, and the contents were stirred. Subsequently, LiTFSI or TPFPB, which was used as the p-type dopant, was added in the amount shown in Table 1. In this manner, the second electrode was formed on the hole transport layer. Au was formed on the second electrode to a thickness of 200 nm by vapor deposition. In this manner, an auxiliary electrode was formed.

### (Comparative Example 2)

A solar cell of Comparative Example 2 was produced as in Examples 10 to 18, except that no p-type dopant was added to the carbon ink that was added dropwise onto the hole transport layer.

### (Measurement of Mass of P-type Dopant Present in Second Electrode)

The mass of LiTFSI and the mass of TPFPB in the second electrode of the solar cells of Examples 10 to 18 were measured as in Examples 1 to 9, and the concentration of the p-type dopant in the second electrode was calculated. Table 2 shows the concentration of the p-type dopant in the second electrode of the solar cells of Examples 10 to 18.

### (Evaluation 3)

A property of the produced solar cells of Examples 10 to 18 and Comparative Example 2 was evaluated under fluorescent light. The fluorescent light (illuminance: 200 lx) was projected onto the solar cells in a manner such that the light entered the solar cells from the glass surface side, the glass being the substrate. The glass surface had a light-blocking mask attached thereto, and the light-blocking mask had an opening area shape of 0.4 cm × 0.25 cm, so that a light-receiving area could be defined. A current value at an operating voltage of 0.6 V was measured with a source meter (6246, manufactured by ADC Corporation). Table 2 shows the current values at Vop=0.6 V at an illuminance of 200 lx of the solar cells of Examples 10 to 18 and Comparative Example 2.

### (Evaluation 4)

A property of the produced solar cell devices of Examples 10 to 18 and Comparative Example 2 was evaluated under simulated sunlight. The light, at 1 sun intensity, was projected onto the solar cells with a solar simulator in a manner such that the light entered the solar cells, via a light-blocking mask, from the glass surface side, the glass being the substrate. The light-blocking mask had an opening area shape of 0.4 cm × 0.25 cm. A voltage-current characteristic over a voltage range of -0.2 V to +1.2 V was measured with a source meter (6246, manufactured by ADC Corporation), and the power at a maximum power point was determined. Table 2 shows the maximum powers of the solar cells of Examples 10 to 18 and Comparative Example 2.

**[Table 2]**

| | Composition of ink for second electrode | | | | | P-type dopant concentration in second electrode (wt/wt) | 200-lx performance | 1-SUN performance |
|---|---|---|---|---|---|---|---|---|
| | Acetylene black (g) | Cellulose (g) | LiTFSI (g) | TPFPB (g) | 2-Propanol (g) | | Current at Vop=0.6 V (µA/cm²) | Maximum power (mW/cm²) |
| Comparative Example 2 | 9.0 | 1.0 | 0.00 | 0.00 | 30.7 | 0.000 | 16.5 | 5.08 |
| Example 10 | 9.0 | 1.0 | 0.00 | 0.04 | 30.8 | 0.004 | 23.9 | 11.06 |
| Example 11 | 9.0 | 1.0 | 0.00 | 0.17 | 31.0 | 0.017 | 23.8 | 10.55 |
| Example 12 | 9.0 | 1.0 | 0.00 | 1.62 | 33.2 | 0.139 | 24.2 | 11.55 |
| Example 13 | 9.0 | 1.0 | 0.00 | 4.85 | 38.1 | 0.326 | 24.2 | 10.12 |
| Example 14 | 9.0 | 1.0 | 0.00 | 9.69 | 45.5 | 0.492 | 24.0 | 11.18 |
| Example 15 | 9.0 | 1.0 | 0.00 | 17.4 | 30.7 | 0.635 | 23.2 | 10.24 |
| Example 16 | 9.0 | 1.0 | 0.00 | 34.8 | 30.7 | 0.777 | 24.0 | 11.45 |
| Example 17 | 9.0 | 1.0 | 1.62 | 0.00 | 33.2 | 0.139 | 23.4 | 10.14 |
| Example 18 | 9.0 | 1.0 | 4.85 | 0.00 | 38.1 | 0.326 | 18.9 | 10.96 |

### (Discussion 2)

As shown in Table 2, the values regarding Evaluation 3 and Evaluation 4 of Examples 10 to 16 are greater than the values regarding Evaluation 1 and Evaluation 2 of Comparative Example 2. The inclusion of TPFPB, which is a p-type dopant, in the second electrode improves the properties of the solar cells. Furthermore, the properties of the solar cells are improved when the concentration of TPFPB in the second electrode is within a range of 0.4 mass% to 77.7 mass%.

The current values regarding Evaluation 3 and the values of the maximum power regarding Evaluation 4 of Examples 17 and 18 are greater than those of Comparative Example 2. This indicates that even when the p-type dopant included in the second electrode is LiTFSI while the p-type dopant already included in the hole transport layer is TPFPB, the properties of the solar cells are improved. That is, it was demonstrated that the p-type dopant included in the second electrode is not limited to the p-type dopant present in the hole transport layer, that is, may be a different material. Furthermore, from Tables 1 and 2, it is apparent that the inclusion of a p-type dopant in the second electrode improves the properties of electronic devices, regardless of the type of the p-type dopant included in the hole transport layer.

### Industrial Applicability

Electronic devices of the present disclosure provide improved performance in terms of initial and long-term reliability, compared with those of the related art, and are, therefore, useful.

### Reference Signs List

1, 11 substrate
2, 12 first electrode
3, 13 electron transport layer
4, 14 photoelectric conversion layer
5, 15 hole transport layer
6, 16 second electrode
7, 17 auxiliary electrode
100, 200, 300, 400 solar cell

## Claims

1. An electronic device comprising a first electrode, a photoelectric conversion layer, a hole transport layer, and a second electrode that are disposed in the order stated, wherein
the second electrode comprises a conductive material and a first p-type dopant.

2. The electronic device according to claim 1, wherein
the second electrode comprises a dopant layer and a conductive layer,
the dopant layer comprises the first p-type dopant, and
the conductive layer comprises the conductive material and is substantially free of the first p-type dopant.

3. The electronic device according to claim 2, wherein the dopant layer is in contact with the hole transport layer.

4. The electronic device according to any one of claims 1 to 3, wherein the second electrode further comprises a binder.

5. The electronic device according to any one of claims 1 to 4, wherein the hole transport layer comprises at least one selected from the group consisting of poly(bis(4-phenyl)(2,4,6-trimethylphenyl))amine, N²,N²,N^{2'},N^{2'},N⁷,N⁷,N^{7'},N^{7'}-octakis(4-methoxyphenyl)-9,9'-spirobi[9H-fluorene]-2,2',7,7'-tetraamine, dithiophene-benzene copolymers, poly(3-hexylthiophene), and poly(3-hexylthiophene)-polystyrene block polymers.

6. The electronic device according to any one of claims 1 to 5, wherein the first p-type dopant comprises at least one selected from the group consisting of metal salts comprising a bis(trifluoromethanesulfonyl)imide group; metal salts comprising a bis(fluorosulfonyl)imide group; metal salts comprising a bis(pentafluoroethylsulfonyl)imide group; metal salts comprising a 4,4,5,5-tetrafluoro-1,3,2-dithiazolidine-1,1,3,3-tetraoxide group; tris(pentafluorophenyl)borane; 2,3,5,6-tetrafluoro-7,7,8,8-tetracyanoquinodimethane; SnCl₄; SbCLs; FeCl₃; and WO₃.

7. The electronic device according to claim 6, wherein the first p-type dopant comprises at least one selected from the group consisting of lithium bis(trifluoromethanesulfonyl)imide and tris(pentafluorophenyl)borane.

8. The electronic device according to any one of claims 1 to 7, wherein, in the second electrode, a concentration of the first p-type dopant is greater than or equal to 0.4 mass% and less than 100 mass%.

9. The electronic device according to claim 8, wherein the concentration of the first p-type dopant is greater than or equal to 0.4 mass% and less than or equal to 77.7 mass%.

10. The electronic device according to any one of claims 1 to 9, further comprising an electron transport layer, wherein
the electron transport layer is disposed between the first electrode and the photoelectric conversion layer.

11. The electronic device according to any one of claims 1 to 10, wherein the hole transport layer comprises a second p-type dopant.

12. The electronic device according to any one of claims 1 to 11, further comprising an auxiliary electrode electrically connected to the second electrode.
